## Europäisches Patentamt

## European Patent Office

## Office européen des brevets

(11) Veröffentlichungsnummer: **0 080 174**
A2

(19)

# EUROPÄISCHE PATENTANMELDUNG

(12)

(21) Anmeldenummer: 82110669.7

(22) Anmeldetag: 18.11.82

(51) Int. Cl.³: **H 03 K 13/05**

(30) Priorität: 19.11.81 DE 3145889

(43) Veröffentlichungstag der Anmeldung: 01.06.83
Patentblatt 83/22

(84) Benannte Vertragsstaaten: **AT CH DE FR GB IT LI SE**

(71) Anmelder: **SIEMENS AKTIENGESELLSCHAFT, Berlin und München Wittelsbacherplatz 2, D-8000 München 2 (DE)**

(72) Erfinder: **Merchant, Kamal, Dipl.-Phys., Almenrauschweg 8, D-8150 Holzkirchen (DE)**
Erfinder: **Schmitt, Claude, Ing. (grad.), Im Tal 4, D-8017 Ebersberg (DE)**

(54) **Integrierbarer Digital/Analog-Wandler.**

(57)   Die Erfindung bezieht sich auf einen Digital/Analogwandler mit einem R-1R-Leiternetzwerk und gewichteten Wechselschaltern, deren Gesamtheit durch das auszuwertende Digitalsignal gesteuert ist, und die entsprechend dieser Steuerung die einzelnen Anschlüsse des durch eine Referenzspannung beaufschlagten R-2R-Leiternetzwerks mit einem den Ausgang des Digital/Analogwandlers bildenden, gegengekoppelten Operationsverstärkers verbinden. Diese, an sich übliche Schaltung verlangt erfahrungsgemäss einen aufwendigen Abgleich eines in der Gegenkopplungsschleife des Operationsverstärkers vorzusehenden Kopplungswiderstandes. Dieser Aufwand wird erheblich reduziert, wenn gemäß der Erfindung der Digital/Analogwandler mit einer Wichtung der vorgesehenen Wechselschalter derart vorgenommen wird, daß der Innenwiderstand $\varrho_i$ der einzelnen Wechselschalter $S_i$ entsprechend der Beziehung $\varrho_i = r/2^i$ eingestellt ist, wobei die Nummer «i» des betreffenden Wechselschalters $S_i$ mit abnehmender Strombelastung der einzelnen Wechselschalter durch das Leiternetzwerk LW abnimmt und der den niedrigsten Strom führende Wechselschalter $S_o$ die Nummer i = o erhält. Außerdem ist der Widerstand R* in der Gegenkopplungsschleife derart bemessen, daß sein Widerstandswert der Beziehung

$$R^* = R + r/2^{(n+1)}$$

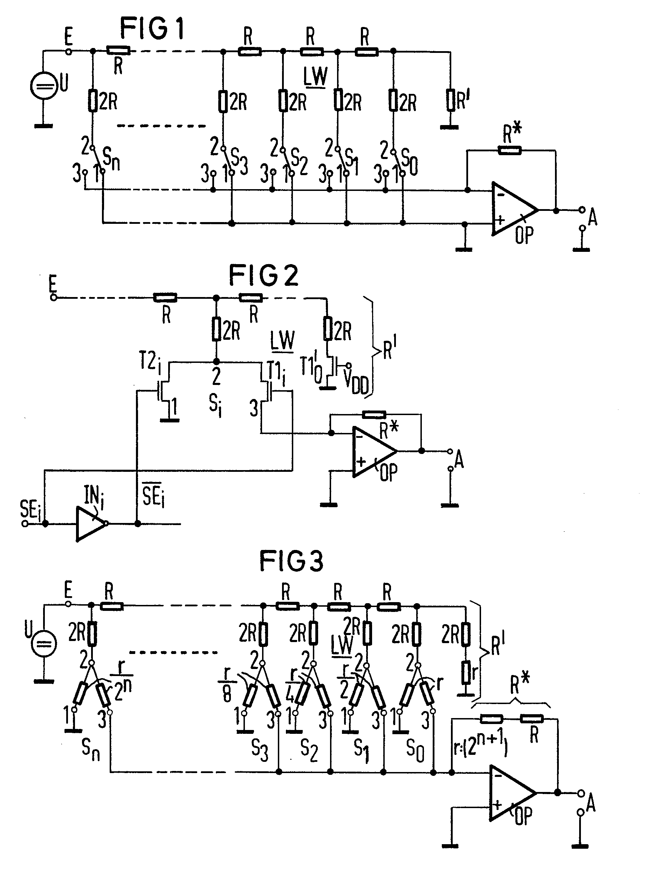

genügt. Dabei ist R der Widerstandsgrundwert im R-2R-Leiternetzwerk. Neben fertigungstechnischen Vorteilen wird durch die Erfindung auch eine Verbesserung der Betriebsgenauigkeit, eine Verminderung der Temperaturdrift sowie eine Unempfindlichkeit gegenüber Prozeßstreuungen erreicht. Außerdem entfällt der Abgleich des Gegenkupplungswiderstands. Die erfindungsgemäße Schaltungsstruktur sowie die Einstellung der Widerstandswerte ist aus Figur 3 ersichtlich.

Siemens Aktiengesellschaft          Unser Zeichen
Berlin und München                  VPA
                                    81 P 1182 E

## Integrierbarer Digital/Analog-Wandler

Die Erfindung beschäftigt sich mit einem integrierbaren Digital/Analog-Wandler, bei dem der eine Anschluß einer Referenz-Gleichspannungsquelle bzw. einer Referenzgleichstromquelle an den Eingang eines Leiternetzwerks und der andere Anschluß dieser Gleichspannungs- bzw. Gleichstromquelle an den ersten stromführenden Anschluß einer Anzahl (n+1) Wechselschalter gelegt ist, die durch je ein Transistorpaar realisiert und gemeinsam durch das auszuwertende Digitalsignal gesteuert sind, bei denen der in beiden Stellungen als stromführender Anschluß beibehaltene zweite Anschluß dieser Wechselschalter mit je einem Ausgang des Leiternetzwerks verbunden und außerdem der dritte stromführende Anschluß aller dieser Wechselschalter an den invertierten Eingang eines gemeinsamen und über einen Widerstand gegengekoppelten sowie den Ausgang des Wandlers bildenden Operationsverstärkers gelegt ist.

Übliche Schaltungen dieser Art haben den aus Figur 1 und 2 ersichtlichen Aufbau. Ihre Wirkungsweise besteht darin, daß nach Maßgabe der digitalen Wertigkeit des umzuwandelnden Eingangssignals durch das Leiternetzwerk an dessen Ausgängen gewichtete Ströme entstehen und diese Ströme über je einen der genannten Wechselschalter an den den Ausgang des Wandlers bildenden Operationsverstärkers gelegt werden und somit eine dem angelegten Digitalsignal entsprechende Beaufschlagung des Operationsverstärkers und damit des Signalausgangs des Digital/Analog-Wandlers hervorrufen.

Hierzu ist bei einem (n+1)-BIT-D/A-Wandler der oben gegebenen Definition in der aus Figur 1 ersichtlichen Weise eine Referenzgleichspannungsquelle U (oder eine Referenzgleichstromquelle) mit ihrem einen Anschluß an

0080174

Masse und mit ihrem anderen Anschluß an den Eingang E eines als R-2R-Netzwerk ausgebildeten Leiternetzwerks LW gelegt. Das Leiternetzwerk LW besteht in der aus Fig. 1 ersichtlichen Weise aus n gleichen und in Serie liegenden Widerständen R, die zusammen einen Spannungsteiler bilden, der mit dem einen Ende E den Eingang des Leiternetzwerks LW bildet und am anderen Ende über einen Abschlußwiderstand R' an Masse gelegt ist. Der Abschlußwiderstand R' hat normalerweise den Wert 2·R. Im Falle der vorliegenden Erfindung wird jedoch der Abschlußwiderstand R' derart ausgestaltet, daß er aus der Serienschaltung des doppelten Grundwiderstands, also eines Widerstands 2R, mit einem Schaltwiderstand $\varrho_0$ besteht, dessen Definition noch gebracht wird.

Offensichtlich bildet der Abschlußwiderstand R' ein Glied des durch die n Grundwiderstände R gebildeten Spannungsteilers und definiert somit einen weiteren Teilerpunkt des aus (n+1) hintereinandergeschalteten Widerständen gebildeten Spannungsteilers. Jeder Teilerpunkt zwischen zwei benachbarten Widerständen der genannten Teilerkette sowie der Eingang E des Spannungsteilers ist über je einen Querwiderstand 2R - also vom doppelten Wert des Grundwiderstands R - an je einen Ausgang 2 des Leiternetzwerks LW gelegt, der mit dem zweiten Anschluß gemäß obiger Definition je eines der vorgesehenen Wechselschalter identisch ist. Das Leiternetzwerk LW hat ersichtlich insgesamt (n+1) solcher Ausgänge 2.

Wie soeben angedeutet, stellt jeder dieser Ausgänge 2 denjenigen stromführenden Anschluß je eines der (n+1) vorgesehenen Wechselschalter $S_0$, $S_1$, $S_2$,...$S_n$ dar, der in beiden Betriebsstellungen des Wechselschalters $S_i$ (i = 0, 1, 2,...n) stromführend ist, während die beiden anderen Anschlüsse 1 und 3 der einzelnen Wechselschalter $S_i$ alternativ nur in der einen bzw. in der anderen Betriebsphase des Wechselschalters leitend und damit stromführend sind, wie sich aus der Darstellung gemäß Figur 1 unmittelbar ergibt.

In der Fig. 1 sind im Leiternetzwerk LW alle Widerstände, deren Widerstandswert dem Grundwert R entspricht, mit "R" und die Widerstände, deren Widerstandswert doppelt so groß ist, mit "2R" bezeichnet. Die Wechselschalter $S_i$ sind als mechanische Schalter dargestellt. Bei der Realisierung der Schaltung eines derartigen D/A-Wandlers werden jedoch Schalttransistoren, insbesondere Feldeffekttransistoren mit isoliertem Gate und vom selbstsperrenden Typ, eingesetzt.

Der an dem zugeordneten (i-ten) Ausgang des Leiternetzwerks LW liegende Anschluß 2 des einzelnen Wechselschalters $S_i$ verbindet je nach Stellung des Schalters $S_i$ den betreffenden Ausgang des Leiternetzwerks über den Anschluß 1 mit Masse oder über den Anschluß 3 des Schalters $S_i$ mit dem invertierenden Eingang "-" des bereits genannten gemeinsamen Operationsverstärkers OP. Letzterer bildet mit seinem Ausgang A den Signalausgang des D/A-Wandlers, der über einen Gegenkopplungswiderstand $R^*$ mit dem - gemeinsam über die Wechselschalter $S_i$ beaufschlagten Eingang "-" verbunden ist. Der nichtinvertierende Eingang "+" des Operationsverstärkers OP liegt hingegen an Masse.

Die digital gesteuerten Wechselschalter $S_i$ sind zweckmäßig in der aus Figur 2 ersichtlichen Weise ausgestaltet, indem sie durch zwei einander gleiche MOS-Feldeffekttransistoren $T1_i$ und $T2_i$ (i = 0, 1,...n), insbesondere vom selbstsperrenden Typ, realisiert werden. Der durch das digitale Eingangssignal zu beaufschlagende Signaleingang $SE_i$ liegt unmittelbar an dem Gate des Transistors $T1_i$, der den jeweiligen Ausgang 2 des Leiternetzwerks LW über seine Source-Drainstrecke mit dem zu beaufschlagenden Eingang "-" des Operationsverstärkers OP verbindet. Das Gate des den besagten Ausgang 2 des Leiternetzwerks LW mit Masse verbindenden anderen Transistors $T2_i$ ist durch den invertierten Signaleingang $\overline{SE_i}$, der aus dem direkten Signaleingang $SE_i$ unter Verwendung eines Inverters $IN_i$ erzeugt ist, gesteuert. Die Schaltung gemäß Fig. 2 gilt im Prinzip für jeden der (n+1) vorgesehenen Wechselschalter $S_i$.

Die anhand von Figur 2 dargestellte und aus bekannten Gründen sehr empfehlenswerte Ausgestaltung für die einzelnen Wechselschalter $S_o$, $S_1$,...$S_n$ kann bekanntlich durch eine binäre Wichtung der Innenwiderstände $\varrho_o$, $\varrho_1$, $\varrho_2$,....$\varrho_n$ der Wechselschalter $S_o$, $S_1$, $S_2$,...$S_n$ weiter verbessert werden, wobei dafür gesorgt wird, daß der Innenwiderstand $\varrho_i$ des Schalters $S_i$ in den beiden Stellungen des Schalters derselbe ist. Dies bedeutet, daß man nach wie vor die beiden Transistoren $T1_i$ und $T2_i$ einander gleich bemißt, daß man aber andererseits durch entsprechende Staffelung der W/L-Verhältnisse dieser Transistoren von Schalter zu Schalter (z.B. durch parallele oder serielle Anordnung von Grundtransistoren t mit identischen Eigenschaften) eine Wichtung der Innenwiderstände $\varrho_i$ der vorgesehenen Wechselschalter $S_i$ von Stufe zu Stufe erhält.

Es empfiehlt sich nun, den Abschlußwiderstand R' im Leiternetzwerk LW so zu bemessen, daß dieser, wie bereits angedeutet, aus einer Serienschaltung eines den doppelten Grundwiderstand R aufweisenden Widerstand 2R mit dem Grundwert $\varrho_o$ für die Innenwiderstände $\varrho_i$ der Schalter $S_i$ aufgebaut wird, wobei der Grundwert $\varrho_o$ dem Innenwiderstand des Schalters $S_o$ (also dem Schalter für die LSB-Stufe) entspricht. Dabei empfiehlt es sich weiter, den den Abschlußwiderstand R' zusammen mit dem Widerstand 2R bildenden Widerstand $\varrho_o$ in identischer Weise wie den Transistor $T1_o$ (=$T2_o$) des Schalters $S_o$ zu realisieren. Aus diesem Grunde ist in Figur 2 der Transistor

T1$_o'$ eingezeichnet, der den Widerstand 2R am Ende des Spannungsteilers im Leiternetzwerk LW über seine Source-Drainstrecke mit Masse verbindet und der bezüglich seiner elektrischen und sonstigen Eingenschaften dem Schalttransistor T1$_o$ bzw. dem Schalttransistor T2$_o$ des Schalters S$_o$ entspricht und dessen Gate mit dem (von dem an Masse liegenden Bezugspotential verschiedenen) anderen Versorgungspotential V$_{DD}$ der Schaltung verbunden ist, so daß der Innenwiderstand des Transistors T1$_o'$ mit dem Innenwiderstand des Transistors T1$_o$ im Wechselschalter S$_o$ weitgehend übereinstimmt. Der Transistor T1$_o'$ befindet sich aufgrund der gezeigten Beaufschlagung beständig im leitenden Zustand.

Der am weitesten von dem durch die Referenzspannungsquelle (bzw. Referenzstromquelle) U beaufschlagten Eingang E des Leiternetzwerks LW entfernte Wechselschalter S$_o$ ist, wie bereits bemerkt, dem LSB des digitalen Eingangssignals zugeordnet und erhält aufgrund der bereits genannten Wichtung den als Grundwert r zu bezeichnenden höchsten Innenwiderstand $\varrho_o = r$. Wenn nun die Nummer i der einzelnen Wechselschalter S$_i$ umso größer wird, je näher der Anschluß 2 dieses Wechselschalters S$_i$ dem von der Referenzspannung (bzw. vom Referenzstrom) beaufschlagten Eingang E des Leiternetzwerks LW liegt, so ergibt sich der einzustellende Innenwiderstand $\varrho_i$ dieses Schalters S$_i$ gemäß der Beziehung

$$\varrho_i = r/2^i = \varrho_o/2^i \quad ( i = 0, 1, 2, \ldots n).$$

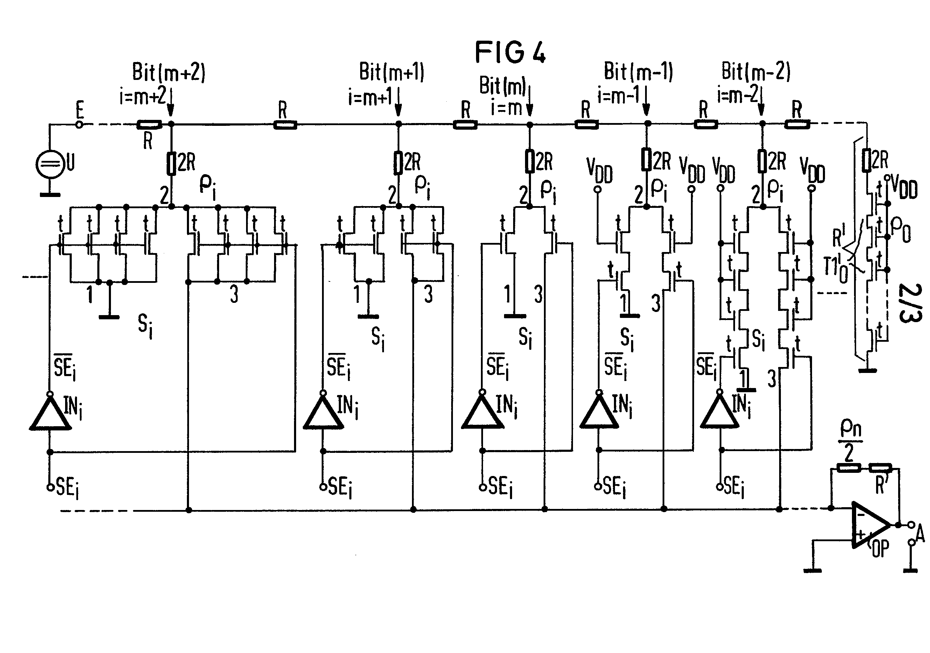

Man kann z.B. zur Realisierung der Transistoren T1$_i$ und T2$_i$ für die eizelnen Schalter S$_i$ mit einer binären Wichtung einander gleiche Transistoren t entweder parallel oder seriell schalten, wobei die einzelnen Transistoren t für die gesamte Schaltung in derselben Weise (z.B. bezüglich der Geometrie und der Dotierung) ausgestaltet sind. Diese Methode ist zur Realisierung ist zur Realisierung der Wechselschalter S$_i$ in Figur 4 angewendet. In Figur 3 ist die gewichtete Einstellung

der Innenwiderstände $\varrho_i$ der einzelnen Wechselschalter ebenfalls angedeutet.

Die Herstellung solcher Digital/Analog-Wandler mit gewichteten Wechselschaltern $S_i$ verlangt erfahrungsgemäß einen aufwendigen Abgleich des Widerstands $R^*$ in der Gegenkopplungsschleife des Operationsverstärkers OP. Es ist deshalb das Ziel der vorliegenden Erfindung, eine Möglichkeit bei Verwendung binär gewichteter Wechselschalter $S_i$ anzugeben, durch deren Anwendung dieser Aufwand erheblich reduziert werden kann.

Um dieses Ziel zu erreichen, wird gemäß der Erfindung bei einem der eingangs gegebenen Definition entsprechenden integrierbaren Digital/Analog-Wandler eine Wichtung der vorgesehenen Wechselschalter $S_i$ (i = 0, 1, ..n) in an sich bekannter Weise derart vorgenommen, daß der Innenwiderstand $\varrho_i$ der einzelnen Wechselschalter $S_i$ entsprechend der Beziehung

$$\varrho_i = r/2^i \quad ( i = 0, 1, 2,..n)$$

eingestellt ist, wobei die Nummer i des betreffenden Wechselschalters $S_i$ mit abnehmender Strombelastung der Wechselschalters $S_i$ durch das Leiternetzwerk LW abnimmt und der den niedrigsten Strom führende Wechselschalter $S_0$ die Nummer "0" erhält, und daß außerdem der Widerstand $R^*$ in der Gegenkopplungsschleife am Operationsverstärker OP derart bemessen ist, daß sein Widerstandswert gleich der Summe aus dem halben Innenwiderstand $\varrho_n = 2^n$ des den höchsten Strom führenden Wechselschalters $S_n$ und dem Grundwiderstand R des Leiternetzwerks LW ist.

Es gilt somit gemäß der Erfindung die Beziehung

$$R^* = R + r/2^{(n+1)}$$

für den Gegenkopplungswiderstand $R^*$ am Operationsverstärker OP. Dies bedeutet also, wie aus Figur 3 ersichtlich, daß neben der an sich bekannten Wichtung der Innen-

widerstände $\rho_i$ der Wechselschalter $S_i$ eine auf diese Wichtung sowie auf den Grundwiderstand R des Leiternetzwerks LW abgestimmte Gegenkopplungsschleife $R^*$ bei einem D/A-Wandler gemäß der Erfindung zur Anwendung gelangt.

Die Bemessung des Rückkoppelwiderstands $R^*$ des Operationsverstärkers OP erfolgt aufgrund der Tatsache, daß der Gesamtwiderstand des D/A-Wandlers den Wert $R + r/2^{(n+1)} = R + \rho_n/2$ hat, was sich aufgrund des Aufbaus des Wandlers aus dem R-2R-Leiternetzwerk LW mit den Widerständen R und 2R sowie aus den binär gewichteten Wechselschalterwiderständen $\rho_i$ ergibt. Der Rückkoppelwiderstand $R^*$ soll aber eben diesem Gesamtwiderstand entsprechen.

Da man, wie bereits angedeutet, die Wichtung der Wechselschalter $S_i$ entsprechend ihrer Nummerierung i auf einfache Weise, vor allem auch in einer integrierten Schaltung realisieren kann, erreicht man eine hohe Genauigkeit in der D/A-Wandlung. Der Aufbau der Gegenkopplung $R^*$ mit den beiden Widerstandsanteilen R und $\rho_n/2$ macht die Schaltung vom Verhältnis der binären Schalterwiderstände $\rho_i$ zu den Widerständen R bzw. 2R im Leiternetzwerk und damit von - durch Prozeßschwankungen und Temperaturverhältnissen bedingten - Schwankungen dieses Verhältnisses bei dem erfindungsgemäßen D/A-Wandler unabhängig, was bei den bekannten D/A-Wandlern nicht der Fall ist. Außerdem entfällt bei der erfindungsgemäßen Ausbildung eines D/A-Wandlers der sonst notwendige aufwendige Abgleich des Gegenkopplungswiderstands $R^*$ am Operationsverstärker OP, weil der Widerstandswert $\rho_n/2$ im Gegenkopplungswiderstand $R^*$ mitintegriert ist.

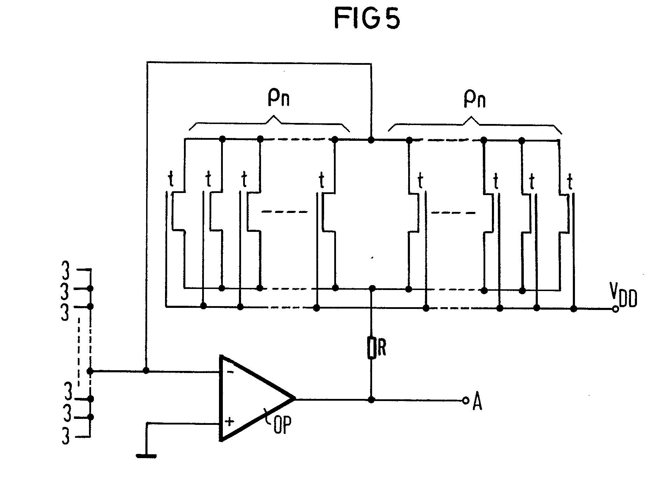

In Figur 4 ist eine zweckmäßige Ausgestaltung der gewichteten Schalter sowie des Abschlußwiderstands R' des Leiternetzwerks LW und in Figur 5 die hierzugehörige
und der Erfindung entsprechende Gegenkopplung des Operationsverstärkers OP gezeigt.

Dabei geht man von der mittleren Stufe bzw. einer der
beiden mittleren Stufen des D/A-Wandlers aus und realisiert deren beide Schalttransistoren $T1_m$ und $T2_m$ durch
je einen MOS-Feldeffekttransistor t, der wie bereits oben angedeutet, als Elementartransistor mit definerten
Eigenschaften, insbesondere mit definiertem Bahnwiderstand $\varrho_m$, auch zur Realisierung der Schalttransistoren
$T1_i$ und $T2_i$ der übrigen Wechselschalter $S_i$ durch Paral-
lel- und Serienschaltung eingesetzt wird. Die in Figur
4 dargestellte mittlere Stufe des D/A-Wandlers (im
Falle daß (n+1) eine ungerade Zahl ist, gibt es eine
mittlere Stufe, im Fall, daß (n+1) gerade ist, hat man
zwei mittlere Stufen) führt den Index "m", so daß der
zugehörige Wechselschalter $S_m$ ist, der in seinen beiden Stellungen den durch je einen der beiden Transistoren $T1_m$ und $T2_m$ zu realisierenden - gleichen -Wert des
Innenwiderstandes $\varrho_m$ hat. Alle einen niedrigeren Innenwiderstand aufgrund der binären Wichtung im Vergleich
zu diesem Wechselschalter $S_m$ aufweisenden Wechselschalter $S_{m+1}$, $S_{m+2}$, ....$S_n$, bestehen aus je zwei Verbundtransistoren $T1_i$, $T2_i$ ( i = m+1, m+2,....n),die ihrerseits durch eine zur Realisierung des gewichteten niedrigeren Innenwiderstands $\varrho_i$ jeweils erforderliche Anzahl von zu
einander parallel liegenden Elementartransistoren t
(mit dem Innenwiderstand $\varrho_m$) realisiert sind. Alle einen höheren Innenwiderstand $\varrho_i$ im Vergleich zu dem durch
die Transistoren $T1_m = T2_m = t$ aufweisenden Wechselschalter $S_{m-1}$, $S_{m-2}$,...$S_o$ hingegen werden durch (einander
gleiche Schalttransistoren $T1_i$, $T2_i$ gebildet, die jeweils
aus einer zur Erreichung des gewichteten Innenwiderstands
$\varrho_i$ des betreffenden Wechselschalters $S_i$ erforderlichen
Anzahl von hintereinandergeschalteten Elementartransistoren t (= $T1_m = T2_m$) bestehen.

Demgemäß bestehen die jeweils einander gleichen Schalttransistoren $T1_i$ und $T2_i$ der einzelnen Wechselschalter $S_i$ bei einer Ausgestaltung gemäß Figur 4 aus jeweils $2^{i-m}$ einander gleicher Elementartransistoren, die im Falle $i > m$ jeweils einander parallel geschaltet und gemeinsam mit ihren Gates an den zugehörigen Signaleingang $SE_i$ bzw. $\overline{SE}_i$ gelegt sind, während im Falle $i < m$ die zur Realisierung des jeweiligen Transistors $T1_i$ bzw. $T2_i$ jeweils erforderliche Anzahl von Elementartransistoren $t$ bezüglich ihrer Source-Drainstrecken hintereinander geschaltet sind. Für den Fall $i = m$ hat man ersichtlich nur einen Elementartransistor $t$ für den Transistor $T1_m$ und einen Elementartransistor $t$ für den Transistor $T2_m$.

Im Interesse eines raschen Ansprechens der Schalttransistoren $T1_i$ und $T2_i$, die durch eine Reihenschaltung von Elementartransistoren $t$ realisiert sind, (also bei den Wechselschaltern $S_{m-1}$, $S_{m-2}$,...$S_o$) wird nur das Gate des jeweils am Operationsverstärker OP bzw. an Masse liegenden Elementartransistors durch den zugehörigen Signaleingang $SE_i$ bzw. $\overline{SE}_i$ beaufschlagt. Die Gates aller übrigen Elementartransistoren $t$ dieser Reihenschaltungen liegen gemeinsam am Versorgungspotential $V_{DD}$ und sind demgemäß im Betrieb dauernd leitend. Hierzu ist allerdings die Anwendung des Versorgungspotentials $V_{DD}$ nicht unbedingt erforderlich.

Der zur LSB-Stufe $i = 0$ gehörende Wechselschalter $S_o$ hat ersichtlich die meisten in Serie geschalteten Elementartransistoren $t$ bei seinen Transistoren $T1_o$ und $T2_o$. Ein weiterer, diesen beiden Transistoren gleicher Transistor $T1_o'$ ist auch im Abschlußwiderstand R' des Leiternetzwerks LW vorgesehen und in Figur 4 angedeutet. Hierbei sind jedoch im Gegensatz zu den Transistoren $T1_o$ bzw. $T2_o$ des Wechselschalters $S_o$ sämtliche Elementartransistoren $t$ in leitendem Zustand.

Das R-2R-Leiternetzwerk LW läßt sich zweckmäßig durch Widerstandsschichten aus polykristallinem Silicium mit entsprechender Formung und entsprechend eingestelltem elektrischen Leitwert realisieren, wobei diese Widerstandsschichten auf einer $SiO_2$-Schicht aufgebracht sind, die von dem die übrigen Teile des D/A-Wandlers aufnehmenden monokristallinen Siliciumchip getragen wird.

Für die Erfindung ist nun wesentlich, daß, wie in Figur 5 dargestellt, der Gegenkopplungswiderstand $R^*$ aus der Serienschaltung eines im Widerstandswert dem Grundwiderstand R im Leiternetzwerk LW gleichen Widerstands und eines Widerstands vom Wert $\rho_n/2 = r/2^{(n+1)}$ realisiert wird. Aus diesem Grund wird zwecks Verbindung des invertierenden Eingangs E "-" des Operationsverstärkers OP mit dem Ausgang A dieses Operationsverstärkers eine aus zwei Verbundtransistoren, entsprechend den Transistoren $T1_n$ bzw. $T2_n$ des Wechselschalters $S_n$ in der dem MSB des D/A-Wandlers zugeordneten n-ten Stufe aufgebaute Parallelschaltung aus den Elementartransistoren t mit einem der Realisierung der Widerstände R im Leiternetzwerk LW entsprechenden Widerstand R in Reihe geschaltet und diese Reihenschaltung einerseits an den besagten Eingang "-" und andererseits an den Ausgang A des Operationsverstärkers OP angeschlossen. Dabei empfiehlt es sich, wenn die parallelgeschalteten und aufgrund des an ihren Gates liegenden Potentials $V_{DD}$ sich während des Betriebs permanent im leitenden Zustand befindlichen Elementartransistoren t dieser den Gegenkopplungswiderstand $R^*$ bildenden Verbundschaltung mit ihren stromführenden Strecken unmittelbar am Eingang "-" liegen. Der Widerstand $R^*$ in der Gegenkopplungsschleife enthält somit insgesamt $2^{(|n-m|+1)}$ Elementartransistoren t.

Der Operationsverstärker OP kann z.B. in der aus "IEEE Journal of Solid-State Circuits" SC-16 (August 1981), S. 318 oder 330, ersichtlichen Weise in CMOS-Technik realisiert werden. Zweckmäßig wird man den Operationsverstärker OP mit den Wechselschaltern $S_i$ und den Invertern $IN_i$ sowie das Leiternetzwerk LW in einem Chip monolithisch zusammenfassen und die zu seiner Realsierung anzuwendende Technik der für die Realsierung der Inverter anzuwendenden Technik (Ein-Kanal-MOS-Technik oder CMOS-Technik) anpassen. Die Realisierung der Transistoren t bzw. $T1_i$ und $T2_i$ in n-Kanaltechnik ist wegen der höheren Schaltgeschwindigkeit günstiger als eine Realisierung in p-Kanaltechnik. Die Schaltung kann aber auch in Bipolartechnik realisiert sein, wobei dann die Transistoren durch entsprechende Bipolartransistoren ersetzt werden. In der Praxis hat sich die beschriebene Realisierung in MOS-Technik besonders bewährt.

5 Figuren
6 Patentansprüche

## Patentansprüche

1.) Integrierbarer Digital/Analog-Wandler, bei dem der eine Anschluß einer Referenz-Gleichspannungsquelle bzw. einer Referenzgleichstromquelle an den Eingang eines Leiternetzwerks und der andere Anschluß dieser Gleichspannungs- bzw. Gleichstromquelle an den ersten stromführenden Anschluß einer Anzahl $(n+1)$ Wechselschalter gelegt ist, die durch je ein Transistorpaar realisiert und gemeinsam durch das auszuwertende Digitalsignal gesteuert sind, bei denen der in beiden Stellungen als stromführender Anschluß beibehaltene zweite Anschluß dieser Wechselschalter mit je einem Ausgang des Leiternetzwerks verbunden und außerdem der dritte stromführende Anschluß aller dieser Wechselschalter an den invertierten Eingang eines gemeinsamen und über einen Widerstand gegengekoppelten sowie den Ausgang des Wandlers bildenden Operationsverstärkers und der erste Anschluß der Wechselschalter an Masse gelegt ist, <u>dadurch gekennzeichnet</u>, daß eine Wichtung der vorgesehenen Wechselschalter ($S_i$; $i = 0, 1, 2,...n$) in an sich bekannter Weise derart vorgenommen ist, daß der Innenwiderstand $\varrho_i$ der einzelnen Wechselschalter $S_i$ entsprechend der Beziehung $\varrho_i = r/2^i$ eingestellt ist, wobei die Nummer i des betreffenden Wechselschalters ($S_i$) mit abnehmender Strombelastung der Wechselschalter ($S_i$) durch das Leiternetzwerk (LW) abnimmt und der den niedrigsten Strom führende Wechselschalter ($S_0$) die Nummer "0" erhält, und daß außerdem der Widerstand ($R^*$) in der Gegenkopplungsschleife am Operationsverstärker (OP) derart bemessen ist, daß sein Widerstandswert gleich der Summe aus dem halben Innenwiderstand ($\varrho_n = 2^n$) des den höchsten Strom führenden Wechselschalters ($S_n$) und dem Grundwiderstand des Leiternetzwerks (LW) ist.

2.) Anordnung nach Anspruch 1, <u>dadurch gekennzeichnet</u>, daß der Widerstand ($R^*$) in der Gegenkopplungsschleife durch die Hintereinanderschaltung zweier Schaltungsteile realisiert ist, von denen der eine entsprechend den Grundwiderständen (R) im Leiternetzwerk (LW) und der andere durch die Parallelschaltung zweier Transistoren gegeben ist, die den Transistoren ($T1_n$ bzw. $T2_n$) des den höchsten Strom aus dem Schalternetzwerk (LW) erhaltenden Wechselschalters ($S_n$) gleich sind.

3.) Anordnung nach Anspruch 2, <u>dadurch gekennzeichnet</u>, daß die Wichtung der Wechselschalter ($S_i$) durch die Parallel- und/oder Serienschaltung einer durch die Zahl $2^{i-m}$ gegebenen Anzahl einander gleicher Elementartransistoren (t) gegeben ist, wobei m eine der Zahlen 0,1,...n, insbesondere die Zahl n/2 oder (n±1)/2, ist.

4.) Anordnung nach Anspruch 3, <u>dadurch gekennzeichnet</u>, daß der Betriebszustand des ersten Anschlusses (1) der vorgesehenen Wechselschalter ($S_i$) über je einen Inverter ($IN_i$) und der Betriebszustand des dritten Anschlusses dieser Wechselschalter unmittelbar durch den mit dem auszuwertenden Digitalsignal beaufschlagten Signaleingang ($SE_i$) des betreffenden Wechselschalters gesteuert ist.

5.) Anordnung nach einem der Ansprüche 1 bis 4, <u>dadurch</u> <u>gekennzeichnet</u>, daß der die Verbindung des als R-2R-Netzwerk ausgestalteten Leiternetzwerks (LW) mit Masse bildende Endwiderstand (R') aus der Serienschaltung eines Widerstands vom Wert des doppelten Grundwiderstands 2R des Netzwerks (LW) und eines in Flußrichtung geschalteten Widerstands vom Wert des Innenwiderstands ($\varrho_o$) des den niedrigsten Strom führenden Wechselschalters ($S_o$) besteht.

6.) Anordnung nach einem der Ansprüche 1 bis 5, <u>dadurch</u> <u>gekennzeichnet</u>, daß die in der Schaltung verwendeten Transistoren einschließlich der Transistoren in den Invertern ($IN_i$) und dem Operationsverstärker (OP) durch MOS-Feldeffekttransistoren gegeben sind.

FIG 1

FIG 2

FIG 3

FIG 4

2/3

0080174

FIG 5